# EUROPÄISCHE PATENTSCHRIFT

(11) **EP 0 472 555 B1**
(45) Veröffentlichungstag und Bekanntmachung des Hinweises auf die Patenterteilung: **23.03.1994**
(21) Anmeldenummer: 90906992.4
(22) Anmeldetag: 10.05.1990
(51) Int. Cl.: H03M 1/68

(54) **D/A-WANDLER MIT HOHER LINEARITÄT**
HIGH LINEARITY D/A CONVERTER
CONVERTISSEUR NUMERIQUE-ANALOGIQUE A HAUTE LINEARITE

(30) Priorität: 18.05.1989 DE 3916202
(43) Veröffentlichungstag der Anmeldung: 04.03.1992
(73) Patentinhaber: Deutsche Thomson-Brandt GmbH, 78003 Villingen-Schwenningen (DE)
(72) Erfinder: GLEIM, Günter, D-7730 VS-Villingen 22 (DE)
(74) Vertreter: Einsel, Robert, Dipl.-Ing.
(86) Internationale Anmeldenummer: EP9000750
(87) Internationale Veröffentlichungsnummer: WO9014717

(56) Entgegenhaltungen:
- DE-A- 3 025 932
- US-A- 3 995 266
- US-A- 4 410 879

## Beschreibung

Die vorliegende Erfindung betrifft ein Verfahren zur Umwandlung einer digitalen Eingangsgröße in eine analoge Ausgangsgröße mit Hilfe eines Digital-Analog-Wandlers.

Um einen großen Quantisierungsbereich mit einem Digital-Analog-Wandler abzudecken, muß dieser für eine hohe Anzahl Bits ausgelegt sein. Die Kosten für derartige Digital-Analog-Wandler sind sehr hoch. Es ist bekannt, deshalb zur Kosteneinsparung Wandler zu verwenden, die keinen so großen Quantisierungsbereich verarbeiten können. Man erzielt einen großen Bereich dadurch, daß der Digital-Analog-Wandler innerhalb seines speziellen Quantisierungsbereichs Ausgangsspannungen in feinen Abstufungen liefert. Am Ausgang werden bei Erreichen des Endes des Quantisierungsbereichs zusätzliche Strom- bzw. Spannungsquellen zugeschaltet, wobei jede Quelle die Ausgangsspannung um einen Schritt des Digital-Analog-Wandlers grob verändert und der Wandler für den nächsten angrenzenden Schritt wieder die Anderung der analogen Ausgangsgröße in feinen Schritten vornimmt. Durch Bauteiltoleranzen des Wandlers und der angeschalteten zusätzlichen Quellen für die grobe Einstellung des analogen Ausgangswertes sowie durch Wärmedriften und Alterung entspricht der grobe Schritt für den angrenzenden Bereich selten dem Wert, der durch den Digital-Analog-Wandler am Ende geliefert wurde. Dieser grobe Schritt kann eine unstetige Stelle nach höheren oder niedrigeren Werten im sonst stetigen Verlauf der erzeugten Ausgangsfunktion hervorrufen.

Es ist z.B. bekannt, bei einer Schaltung zur automatischen Sendersuche die Abstimmspannung in digitalen Stufen zu verändern, indem der gesamte Abstimmspannungsbereich in groben Schritten und innerhalb dieser groben Schritte die Abstimmspannung in feinen Schritten veränderbar ist. Am Ende des groben Schrittes, der in feinen Schritten durchlaufen wurde, wird der nächste grobe Schritt eingeschaltet. Der Anfang dieses groben Schrittes kann nun oberhalb des zuletzt eingestellten Wertes liegen, so daß von diesem wiederum in feinen Schritten ausgehend Abstimmspannungswerte nicht erfaßt werden. In der bekannten Schaltungsanordnung wird daher bei übergang um den nächsten groben Schritt dafür gesorgt, daß der Anfang des neu eingestellten groben Schrittes immer unterhalb des zuletzt erreichten Wertes liegt, weil diese Maßnahme sicher verhindert, daß Abstimmspannungen und somit auch Sender übersprungen werden (DE-A-30 37 021). Diese Maßnahme verhindert jedoch nicht, daß ein Sprung in der Ausgangsfunktion entsteht. Bei einem Sendersuchlauf mag dies zwar nicht stören, in anderen Fällen stört jedoch eine derartige Unstetigkeit, z.B. bei Einstellung der Lautstärke in einer Tonwiedergabeanordnung.

Wie in der US-A-4,410,879 beschrieben, ist es bekannt, die Auflösung eines Digital-Analog-Wandlers zu vergrößern, indem zwei Wandler in Kaskade geschaltet werden, von denen der erste die niederwertigen Bits und der zweite die höherwertigen Bits verarbeitet. Die Ausgänge der beiden Wandler werden an einen Summierverstärker gegeben, dessen Ausgang mit einem integrierenden Verstärker verbunden ist, der ein Signal an den negativen Eingang des Summierverstärkers liefert, so daß dieser den Ausgang des Summierverstärkers immer auf den Wert Null zu halten versucht. Wenn der niederwertige Wandler seinen höchsten Wert erreicht hat, wird der Ausgang des Summierverstärkers vom Eingang des integrierenden Verstärkers abgetrennt und der höherwertige Wandler um einen Schritt nach oben erhöht, während der niederwertige Wandler auf Null gesetzt wird. Während der Umschaltung wird der letzte Wert des analogen Ausgangs festgehalten.

Aus der US-A-3,995,266 ist es auch bekannt, mit Hilfe vcn zwei Digital-Analog-Wandlern in groben und feinen Schritten veränderbare Steuerspannungen zu erzeugen, welche über einen Stromverstärker zur Steuerung von Magnetfeldlinsen eines elektronischen Mikroskops dienen. Hierbei handelt es sich um eine Regelschaltung, die dafür sorgt, daß der Arbeitspunkt des Aussteuerbereichs immer in der Mitte des grobschrittigen Wandlers liegt, damit die Grenzen des groben Schrittes immer in gleicher Anzahl von feinen Schritten erreicht werden.

Der Erfindung liegt die Aufgabe zugrunde, die Methode der Digital-Analog-Wandlung mit Hilfe eines Digital-Analog-Wandlers kleinen Quantisierungsbereichs mit zuschaltbaren Quellen dahingehend zu verbessern, daß die unstetigen Stellen in der Ausgangsfunktion verschwinden. Diese Aufgabe wird durch die im Patentanspruch angegebene Erfindung gelöst.

Nachstehend wird die Erfindung mit Hilfe der Zeichnung erläutert.
- Figur 1: zeigt einen nach dem Stand der Technik bekannten Schaltungsaufbau
- Figur 2: zeigt einen zu Figur 1 gehörenden Kurvenverlauf
- Figur 3: zeigt eine Schaltung nach der Erfindung
- Figur 4: und
- Figur 5: zeigen Kurven zu Figur 3
- Figur 6: zeigt ein vereinfachtes Schaltbild der Erfindung
- Figur 7: dient zur Erläuterung der Figur 6
- Figur 8: zeigt ein weiteres Ausführungsbeispiel der Erfindung
- Figur 9: dient zur Erläuterung der Figur 8

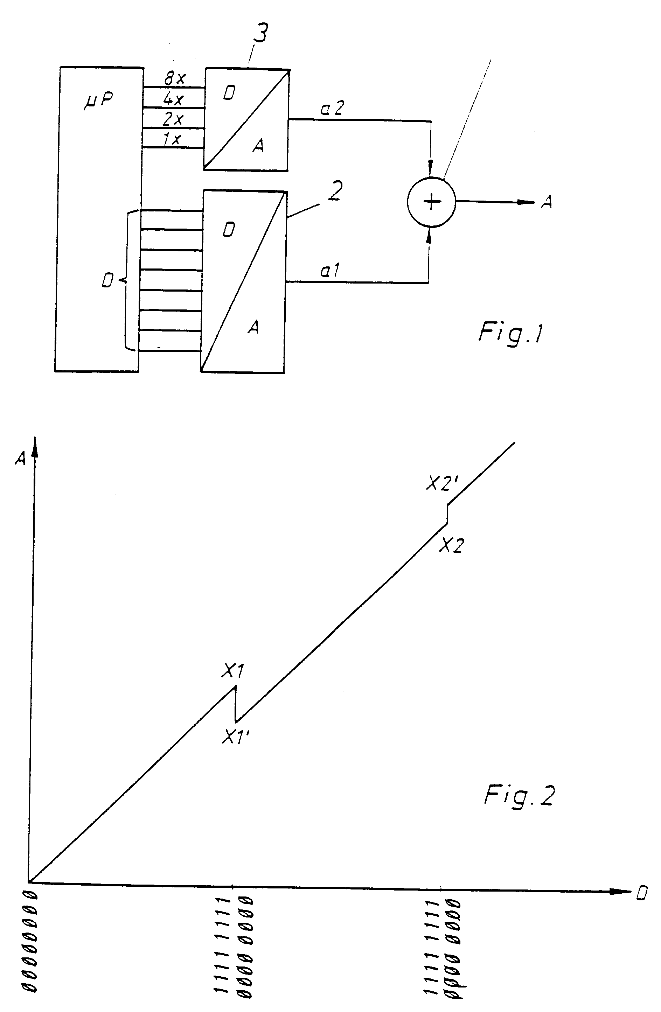

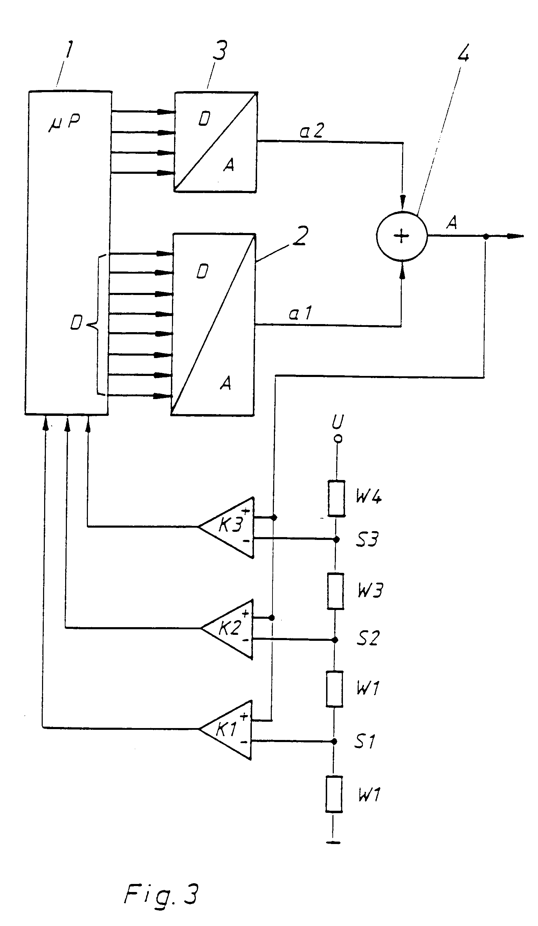

Zunächst ist in Figur 1 in Verbindung mit Figur 2 an einem Beispiel dargestellt und beschrieben, wie eine Schaltung nach dem Stand der Technik arbeitet. Eine Steuerschaltung, z.B. ein Mikroprozessor 1 gibt an seinen Ausgängen D ein binäres Signal ab, welches von 0000 0000 bis 1111 1111 in digitalen Schritten inkrementiert wird. Dieses digitale Signal wird auf einen Digital-Analog-Wandler 2 gegeben, an dessen Ausgang a1 das analoge in feinen Schritten sich ändernde Ausgangssignal abnehmbar ist. Wenn der digitale Wert 1111 1111 erreicht ist, schaltet der Mikroprozessor 1 den Ausgang D bei weiterer Erhöhung des zu erzeugenden Ausgangssignals auf 0000 0000 und zusätzlich über einen weiteren Digital-Analog-Wandler 3 über den Ausgang a2 um eine groben Schritt weiter, der dem Quantisierungsbereich des Digital-Analog-Wandlers 2 entspricht. Beide Ausgänge a1 und a2 werden über eine Summierstufe 4 an den Ausgang A gegeben, an welchem das analoge Signal abnehmbar ist. Der Digital-Analog-Wandler 3 ist als Vier-Bit-Wandler dargestellt, so daß dieser in der Lage ist an seinem Ausgang a2 sechzehn grobe Schritte zu erzeugen. Der Digital-Analog-Wandler 3 kann auch durch entsprechende digital zuschaltbare Stromquellen oder Spannungsquellen ersetzt werden. Der durch diese Anordnung in n Schritten erfaßbare Bereich ist durch die Beziehung n(2⁸-1) festgelegt.

Wie in Figur 2 dargestellt, ergeben sich an den ubergangsstellen vom großen Schritt zur nächsten feinen Stufe Unstetigkeiten, weil die großen Schritte dem Quantisierungsbereich des Digital-Analog-Wandlers nicht genau entsprechen, z.B. infolge von Bauteiltoleranzen oder durch andere Einflüsse. Eine solche Unstetigkeit kann sich in einer Signaländerung nach unten wie bei X1 dargestellt nach X1' oder nach oben wie bei X2 dargestellt nach X2'ergeben. Ein derartiger Signalverlauf ist jedoch aus oben genannten Gründen unerwünscht.

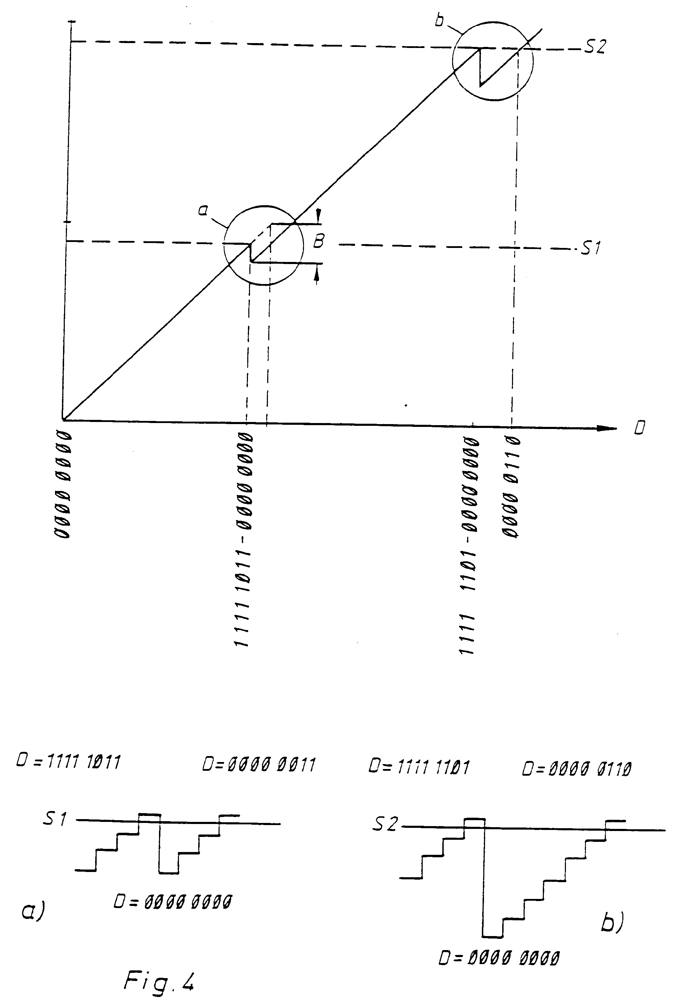

Um diesem Mißstand abzuhelfen wurde die Schaltung gemäß Figur 3 aufgebaut, deren Wirkungsweise in Verbindung mit Figur 4 verständlich gemacht wird. Es wird angenommen, daß drei Schwellwerte S1 bis 53 erzeugt werden sollen. Zusätzlich zur bekannten Anordnung sind dazu drei Komparatoren K1, K2 und K3 an den Ausgang A gelegt, welche aie erzeugte Ausgangsspannung mit unterschiedlichen Referenzspannungen vergleichen. Diese unterschiedlichen Referenzspannungen können z.B. durch einen an eine feste Bezugsspannung U gelegten Spannungsteiler erzeugt werden, der aus den Widerständen W1, W2, W3 und W4 besteht. Sie können aber auch über einen weiteren Digital-Analog-Wandler gebildet werden. Der jeweilige Schwellwert muß dabei unterhalb des Wertes liegen, der beim Eingangswert 1111 1111 des Digital-Analog-Wandlers 2 beim (n)ten groben Schritt erreicht würde und oberhalb des Wertes, der sich beim Eingangswert 0000 0000 des Digital-Analog-Wandlers 2 beim (n+1)ten groben Schritt einstellt. Auf diese Weise entsteht ein überlappungsbereich mit der Weite B. Sobald die Ausgangsspannung einen dieser Schwellwerte überschreitet, gibt der entsprechenden Komparator K1, K2 bzw. K3 an den Mikroprozessor 1 ein Signal ab, welcher daraufhin den nächsten groben Schritt einleitet und gleichzeitig den Digital-Analog-Wandler 2 mit einem Offset beaufschlagt.

Zur Erläuterung der Wirkungsweise der Schaltung dient Figur 4. Es wird angenommen, daß der Ausgang D des Mikroprozessors 1 mit dem Wert 0000 0000 beginnend digital in bekannter Weise inkrementiert wird. Noch vor Erreichen seines Endwertes 1111 1111 innerhalb des ersten groben Schrittes wird das Signal am Ausgang A den Schwellwert S1 erreichen, die z.B. dem Wert 1111 1011 entsprechen möge. Dieser Wert oder der bis zum Erreichen des Endwertes sich ergebende Unterschiedswert wird in einen Speicher des Mikroprozessors 1 abgelegt. Gleichzeitig wird der Ausgang D auf 0000 0000 gesetzt und. der nächste grobe Schritt eingeschaltet, welcher unterhalb des Schwellwertes S1 liegen soll. Von da ab wird der Digital-Analog-Wandler 2 erneut inkrementiert, bis der Schwellwert S1 wieder erreicht wird. Auch dieser digitale Wert, z.B. 0000 0011 wird abgespeichert. Zur Verdeutlichung ist diese Stelle des Kurvenverlaufs in größerer Auflösung in Figur 4a dargestellt. Bei der weiteren Inkrementierung wird innerhalb des ersten groben Schrittes der Schwellwert S2 erreicht, der dem digitalen Eingangssignal 1111 1101 entsprechen möge, welcher abgespeichert wird. Auch hier kann wieder die Differenz zum Endwert abgespeichert werden. Mit Nullsetzen des digitalen Eingangssignals wird der zweite grobe Schritt eingeschaltet und der Digital-Analog-Wandler 2 inkrementiert, bis er wieder den Schwellwert S2 erreicht, z.B. bei dem digitalen Eingangswert 0000 0110, der wieder abgespeichert wird. Dieser Moment ist in Figur 4b vergrößert dargestellt.

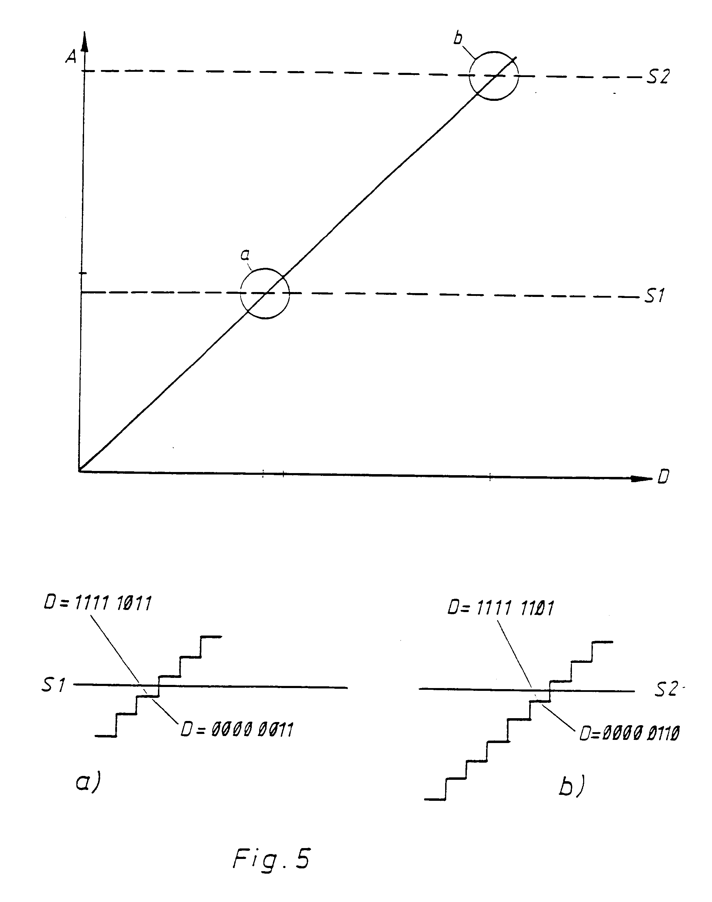

In Figur 5 ist die Ausgangsfunktion des Digital-Analog-Wandlers 2 dargestellt, wie sie sich nach der erstmaligen Eichung und Abspeicherung ergibt. Man erkennt deutlich, daß an den Stellen der Umschaltung auf den nächstgrößeren Schritt keine Unstetigkeit mehr vorliegt.

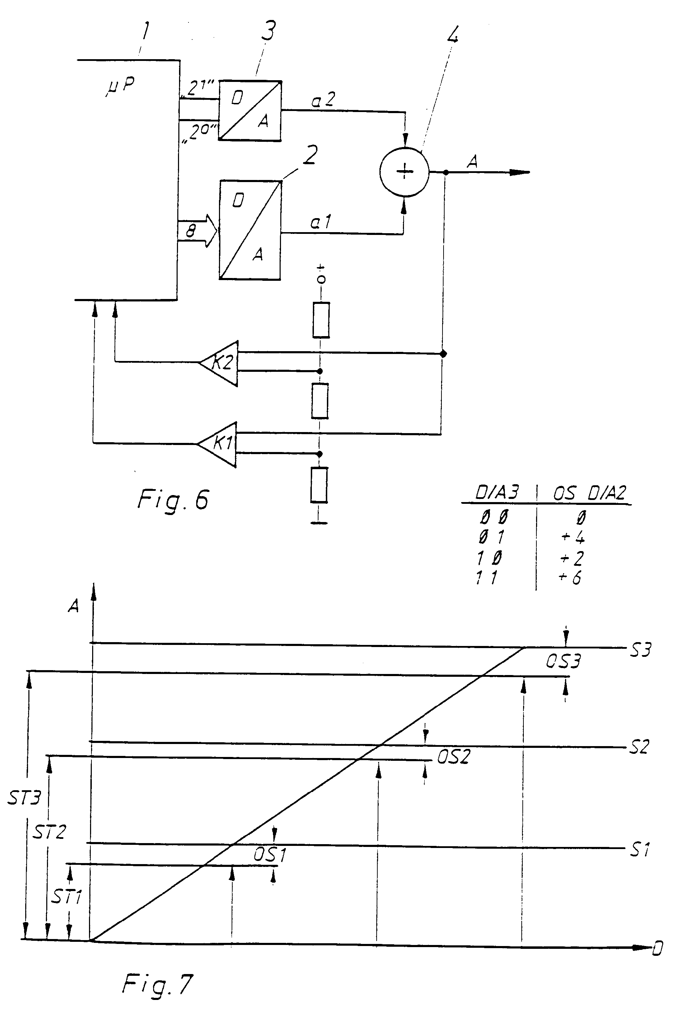

In Figur 6 ist ein vereinfachtes Beispiel für nur vier grobe Schritte dargestellt. Hierzu werden für den groben Digital-Analog-Wandler 3 zwei bit benötigt. Im Gegensatz zum Beispiel nach Figur 3, in welchem (2ⁿ-1)=3 Komparatoren gebraucht würden, bei n=4 wären es in Figur 3 fünfzehn Komparatoren, verringert sich die Anzahl der Komparatoren auf zwei, bei n=4 auf vier. Der erste (2⁰)te Schritt reicht von Null bis zum Schwellwert S1, der zweite (2¹)te Schritt reicht von Schwellwert S1 bis zum Schwellwert S2, der dritte (2⁰+2¹)te Schritt reicht von Schwellwert S2 bis zum Schwellwert S3 und der vierte (2² )te Schritt beginnt beim Schwellwert S3.
Die Erzeugung der Offset-Werte für den Digital-Analog-Wandler 2 für den übergang in einen nächsten groben Schritt erfolgt hier in der Weise, daß diese entsprechend der Wertigkeiten der Ansteuerung des Digital-Analog-Wandlers 3 abgespeichert werden, so daß bei der Einleitung eines groben Schrittes der entsprechende Offset-Wert eingestellt wird.

Ein Beispiel soll dieses mit Hilfe der Figur 7 verdeutlichen. Beim ersten (2⁰)ten groben Schritt ST1 wird der Digital-Analog-Wandler 2 mit dem Offset-Wert 0 beaufschlagt. Bei Erreichen des ersten Schwellwertes S1 zur Umschaltung in den zweiten (2¹)ten groben Schritt ST2 sei der ermittelte Offset-Wert OS1 +4, beim dritten groben Schritt ST3 bei Erreichen des zweiten Schwellwertes S2 sei der ermittelte Offset-Wert +2. Bei Erreichen des dritten Schwellwertes S3 zur Umschaltung in den vierten groben Schritt ST4 wird zum Offset-Wert OS3 (+2) des dritten groben Schrittes der abgespeicherte Offset-Wert OS2 (+4) des zweiten groben Schrittes ST2 hinzuaddiert, d.h. es ergibt sich ein neuer Offset-Wert OS3 von +6.

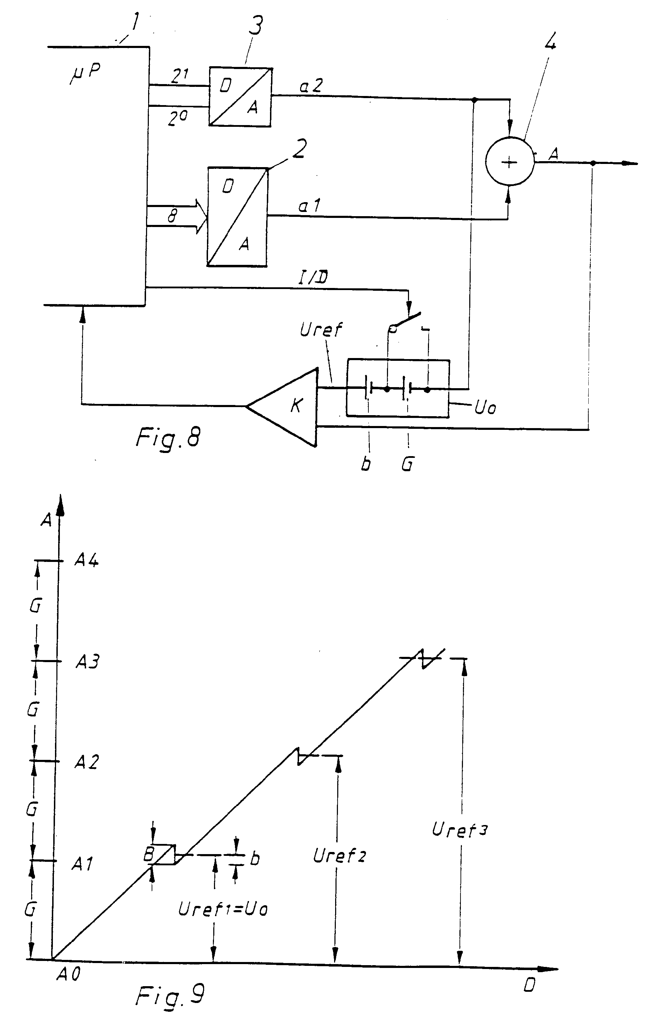

In Figur 8 ist noch ein weiteres Beispiel dargestellt, wie die Umschaltung und Einleitung in einen benachbarten groben Schritt mit nur einem Komparator K bewerkstelligt werden kann. Dazu wird dieser mit seinem ersten Eingang an die erzeugte analoge bei A entstehende Ausgangsspannung gelegt. Der zweite Eingang erhält eine Offset-Spannung, die bei a2 dem Digital-Analog-Wandler 3 entnommen wird, auf welche eine feste Offset-Spannung Uo aufgestockt wird.

In Figur 9 ist dieses näher dargestellt. Es handelt sich hier wieder um den Verlauf der analogen Ausgangsgröße A in Abhängigkeit von dem aigitalen Eingangswert D, wobei wieder die groben Schritte A0, A1, A2, A3 von dem Digital-Analog-Wandler 3 und die innerhalb der groben Schritte liegenden feinen Schritte von dem Digital-Analog-Wandler 2 erzeugt werden. Der erste grobe Schritt beginnt mit dem Wert A0, der zweite grobe Schritt beginnt mit dem Schritt A1 u.s.w. Die Schrittweite eines groben Schrittes sei G. Am Anfang eines vom Digital-Analog-Wandler 3 erzeugten groben Schrittes liefert der Digital-Analog-Wandler 2 seinen minimalen Wert, z.B. Null. Die Schwellwerte Uref1 bis Uref3 liegen jeweils zwischen dem durch den Digital-Analog-Wandler 2 maximal erreichbaren analogen Wert innerhalb eines groben Schrittes n und dem Wert, welcher dem Anfang eines benachbarten groben Schrittes (n+1) entspricht, nachdem der Digital-Analog-Wandler 2 auf Null gesetzt wurde. Die Schwellwerte Uref werden jeweils durch Aufstockung mit der Offsetspannung Uo auf den Wert eines groben Schrittes n erzeugt. Hierbei ist die Größe von Uo bestimmt durch die Größe der Schrittweite G zuzüglich einem Bruchteil b der weiter oben definierten Überlappungsbreite 8 nach der Beziehung Uo = G + b . Vorzugsweise wählt man b zu 0,5 8. So ergeben sich ganz allgemein die Referenzspannungen Uref für den Schritt n zu Urefₙ = Aₙ₋₁ + G + b.

Das soeben Beschriebene bezieht sich auf die Inkrementierung der Ausgangsgröße A. Bei einer Dekrementierung der Ausgangsgröße A müssen aie Referenzsoannungen Uref umgeschaltet werden.

Dies ist in der Figur 8 durch die überbrückung der Spannungsquelle von der Größe G symbolisch dargestellt, die vom Mikroprozessor 1 über die Leitung I/D gesteuert wird. Die Referenzspannungen bei der Dekrementierung ergeben sich demnach für den Schritt n zu
Urefₙ = Aₙ₋₁ + b, d.h. sie sind genau so groß wie die Referenzspannungen des vorhergehenden Schrittes (n-1) bei der Inkrementierung.

## Patentansprüche

1. Verfahren zur Umwandlung einer digitalen Eingangsgröße in eine analoge Ausgangsgröße mit Hilfe eines DigitalAnalog-Wandlers, der die analoge Ausgangsgröße in feinen Schritten inkrementiert, sowie mit einer Anordnung, die die analoge Ausgangsgröße in groben digitalen Schritten verändert, die vor Erreichen des Quantisierungsbereiches des Digital-Analog-Wandlers unter Bildung eines Überlap- pungsbereiches zugeschaltet wird, wobei die Konversionsergebnisse des feinschrittigen Digital-Analog-Wandlers und des grobschrittigen Digital-Analog-Wandlers in einer Addiervorrichtung aufaddiert werden, **dadurch gekennzeichnet**, daß ein Schwellwert (S) innerhalb des uberlappungsbereiches (B) vorgesehen ist und daß bei Feststellung dieses Schwellwertes (S) durch die Ausgangsgröße mit Hilfe einer Komparatorschaltung (K) der dieser entsprechende erste Eingangswert abgespeichert und gleichzeitig der Eingang des Digital-Analog-Wandlers (2) auf Null gesetzt und der grobe Schritt zugeschaltet wird, welcher unterhalb des Schwellwertes (S) liegt, wonach der Digital-Analog-Wandler (2) inkrementiert wird, bis erneut der Schwellwert (S) erreicht wird, und daß der sich ergebende digitale zweite Eingangswert ebenfalls abgespeichert wird, so daß bei der Erzeugung der analogen Ausgangsgröße bei der Inkrementierung des Digital-Analog-Wandlers (2) jeweils bei Erreichen des ersten abgespeicherten digitalen Wertes der grobe Schritt zugeschaltet und der Digital-Analog-Wandler (2) mit dem zweiten abgespeicherten um einen feinen digitalen Schritt erhöhten digitalen Wert als Offset beaufschlagt wird, und daß bei der Dekrementierung des Digital-Analog-Wandlers (2) bei Erreichen des zweiten abgespeicherten digitalen Wertes der grobe Schritt zurückgeschaltet und der Digital-Analog-Wandler (2) mit diesem zweiten abgespeicherten digitalen Wert abzüglich eines feinen Schrittes als Offset beaufschlagt wird.

2. Verfahren nach Anspruch 1, **dadurch gekennzeichnet**, daß mehrere Schwellwerte (S1, S2, ...Sn) im Abstand des Quantisierungsbereichs des Digital-Analog-Wandlers (2) vorgesehen sind, wobei die diese Schwellwerte charakterisierenden digitalen Werte abgespeichert werden.

3. Verfahren nach den Ansprüchen 1 oder 2, **dadurch gekennzeichnet**, daß für die abzuspeichernden ersten und zweiten Werte die Differenzen zur oberen bzw. unteren Grenze des Quantisierungsbereichs des Digital-Analog-Wandlers (2) verwendet werden.

4. Verfahren nach den Ansprüchen 1, 2, oder 3, **dadurch gekennzeichnet**, daß die Komparatoren (K) bei Erreichen eines Schwellwertes (S) ein Signal für die Abspeicherung der digitalen Werte abgeben.

5. Verfahren nach den Ansprüchen 1, 2, 3 oder 4, **dadurch gekennzeichnet**, daß die groben Schritte mit Hilfe von digital zuschaltbaren Stromquellen erzeugt werden.

6. Verfahren nach den Ansprüchen 1, 2, 3 oder 4, **dadurch gekennzeichnet**, daß die groben Schritte mit Hilfe eines weiteren Digital-Analog-Wandlers (3) erzeugt werden.

7. Verfahren nach Anspruch 3, **dadurch gekennzeichnet**, daß die für die Umschaltung als Offset für den Digital-Analog-Wandler (2) dienenden Werte in Abhängigkeit von der Wertigkeit der Ansteuerung des Digital-Analog-Wandlers (3) abgespeichert werden.

8. Verfahren nach den Ansprüchen 1, 2, 3 oder 6, **dadurch gekennzeichnet**, daß zur Umschaltung auf den nächsten groben Schritt ein einziger Komparator (K) verwendet wird, an dessen ersten Eingang die erzeugte analoge Ausgangsgröße angelegt ist und an dessen zweiten Eingang eine Offset-Spannung (Uref) gelegt ist, die dem Wert des groben Schrittes (n*G) des Digital-Analog-Wandlers (3) entspricht auf welchen eine Spannung (Uo) aufgestockt ist, wobei die Spannung (Uo) in Abhängigkeit von der Richtung der Anderung des Ausgangssignals umschaltbar ist, indem sie bei der Inkrementierung des Ausgangssignals dem Wert G+b und bei der Dekrementierung des Ausgangssignals dem Wert b entspricht.

## Claims

1. A method of converting a digital input value to an analog output value by means of a digital-analog converter which increments the analog output value in fine steps, and with an arrangement which changes the analog output value in coarse digital steps and which is connected to the supply before the quantising range of the digital-analog converter is reached, forming an overlapping range, wherein the conversion results of the fine step digital-analog converter and of the coarse step digital-analog converter are added in an adding device, characterised in that a threshold value (S) is provided within the overlapping range (B), that when this threshold value (S) is established by the output value by means of a comparator circuit (K) the first input value corresponding thereto is stored, the input of the digital-analog converter (2) is simultaneously set to zero, and the coarse step below the threshold value (S) is switched in, after which the digital-analog converter (2) is incremented until the threshold value (S) is reached again, that the resultant digital second input value is similarly stored so that, when the analog output value is generated on incrementation of the digital-analog converter (2), whenever the first stored digital value is reached the coarse step is switched in and the digital-analog converter (2) is impinged on as an offset with the second stored digital value increased by one fine digital step, and that on decrementation of the digital-analog converter (2) when the second stored digital value is reached, the coarse step is switched back and the digital-analog converter (2) is impinged on as an offset with this second stored digital value minus one fine step.

2. A method according to claim 1, characterised in that a plurality of threshold values (S1, S2, ...Sn) are provided at a spacing equal to the quantising range of the digital-analog converter (2), and that the digital values characterising these threshold values are stored.

3. A method according to claim 1 or 2, characterised in that the differences from the upper or lower limit of the quantising range of the digital-analog converter (2) are used as the first and second values to be stored.

4. A method according to claims 1, 2 or 3, characterised in that the comparators (K) emit a signal for storing the digital values on reaching a threshold value (S).

5. A method according to claims 1, 2, 3 or 4, characterised in that the coarse steps are generated by means of current sources which can be connected to the supply digitally.

6. A method according to claims 1, 2, 3 or 4, characterised in that the coarse steps are generated by means of a further digital-analog converter (3).

7. A method according to claim 3, characterised in that the values used as an offset for the digital-analog converter (2) for the changeover are stored dependent on the pulse value of the triggering of the digital-analog converter (3).

8. A method according to claims 1, 2, 3 or 6, characterised in that one comparator (K) is used for switching over to the next coarse step, that the analog output value generated is applied to its first input and an offset voltage (Uref), corresponding to the value of the coarse step (nxg) of the digital-analog converter (3) onto which a voltage (Uo) is fed, is applied to its second input, and that the voltage (Uo) can be switched over dependent on the direction of the change in the output signal, the voltage corresponding to the value G+b on incrementation of the output signal and to the value b on decrementation of the output signal.

## Revendications

1. Procédé pour la transformation d'une grandeur d'entrée numérique en une grandeur de sortie analogique à l'aide d'un convertisseur numérique-analogique, qui incrémente la grandeur de sortie analogique en pas fins, ainsi qu'avec un dispositif, qui fait varier la grandeur de sortie analogique en pas numériques grossiers, qui est mis en commutation avant d'atteindre la plage de quantification du convertisseur numérique-analogique en formant une plage de chevauchement, les résultats de la conversion du convertisseur numérique-analogique à pas fins et du convertisseur numérique-analogique à pas grossiers étant additionnés dans un dispositif d'addition, **caractérisé en ce** qu'un seuil (S) est prévu à l'intérieur de la plage de chevauchement (B) et que, lors de la constatation de ce seuil (S) par la grandeur de sortie à l'aide d'un circuit comparateur (K), la première valeur d'entrée qui lui correspond est mémorisée et simultanément l'entrée du convertisseur numériqueanalogique (2) est mise à zéro et le pas grossier qui se situe au-dessous du seuil (S) est mis en circuit, ce après quoi le convertisseur numérique-analogique (2) est incrémenté jusqu'à ce que le seuil (S) soit à nouveau atteint et en ce que la seconde valeur d'entrée numérique qui résulte est également mise en mémoire si bien que, lors de la production de la grandeur de sortie analogique lors de l'incrémentation du convertisseur numérique-analogique (2), le pas grossier est mis en circuit à chaque fois que la première valeur numérique mémorisée est atteinte et que le convertisseur numérique-analogique (2) est chargé de la seconde valeur numérique mémorisée, augmentée d'un pas numérique fin, comme décalage et que, lors de la décrémentation du convertisseur numérique-analogique (2), lorsque la seconde valeur numérique mémorisée est atteinte, le pas grossier est décrémenté et le convertisseur numériqueanalogique (2) est chargé de la seconde valeur numérique mémorisée, déduction faite d'un pas fin, comme décalage.

2. Procédé selon la revendication 1, **caractérisé en ce** que plusieurs seuils (S1, S2,...Sn) sont prévus à un intervalle de la plage de quantification du convertisseur numérique-analogique, les valeurs numériques qui caractérisent ces seuils étant mémorisées.

3. Procédé selon les revendications 1 ou 2, **caractérisé en ce** que, pour les premières et secondes valeurs à mémoriser, les différences avec le seuil supérieur et/ou inférieur de la plage de quantification du convertisseur numérique-analogique (2) sont utilisées.

4. Procédé selon les revendications 1, 2 ou 3, **caractérisé en ce** que les comparateurs (K) donnent un signal pour la mise en mémoire des valeurs numériques, lorsqu'un seuil (S) est atteint.

5. Procédé selon les revendications 1, 2, 3 ou 4, **caractérisé en ce** que les pas grossiers sont produits à l'aide de sources de courant pouvant être mises en circuit numériquement.

6. Procédé selon les revendications 1, 2, 3 ou 4, **caractérisé en ce** que les pas grossiers sont produits à l'aide d'un autre convertisseur numérique-analogique (3).

7. Procédé selon la revendication 3, **caractérisé en ce** que les valeurs qui servent de décalage pour le convertisseur numérique-analogique (2) pour la commutation sont mémorisées en fonction de la valeur significative de l'excitation du convertisseur numérique-analogique (3).

8. Procédé selon les revendications 1, 2, 3 ou 6, **caractérisé en ce** que, pour commuter au prochain pas grossier, un seul comparateur (K) est utilisé à la première entrée duquel la grandeur de sortie analogique produite est appliquée et à la seconde entrée duquel une tension de décalage (Uref) est appliquée qui correspond à la valeur du pas grossier (n*G) du convertisseur numérique-analogique (3) à laquelle une tension (Uo) est rehaussée, la tension (Uo) pouvant être commutée en fonction du sens de la modification du signal de sortie, celle-ci correspondant, lors de l'incrémentation du signal de sortie, à la valeur G+b et, lors de la décrémentatioin du signal de sortie, à la valeur b.
